# EUROPEAN PATENT SPECIFICATION

(11) **EP 4 300 721 B1**
(45) Date of publication and mention of the grant of the patent: **14.10.2026**
(21) Application number: 22190842.9
(22) Date of filing: 17.08.2022
(51) Int. Cl.: H01R 13/641, H01R 13/66, H01R 107/00, H01R 12/72

(54) **ELECTRONIC DEVICE FOR AN AUTOMOTIVE VEHICLE**
ELEKTRONISCHE VORRICHTUNG FÜR EIN KRAFTFAHRZEUG
DISPOSITIF ÉLECTRONIQUE POUR VÉHICULE AUTOMOBILE

(30) Priority: 30.06.2022 FR 2206702
(43) Date of publication of application: 03.01.2024
(73) Proprietor: Valeo Vision, 93012 Bobigny Cedex (FR)
(72) Inventor: ILLAN CABEZA, Antonio Domingo, 23600 MARTOS (ES); CANTUDO FRANCO, Miguel Angel, 23600 MARTOS (ES); PEÑA PULIDO, Miguel Angel, 23600 MARTOS (ES); SANTAELLA HERNANDEZ, Juan Jose, 23600 MARTOS (ES); LARA CABEZA, Juan, 23600 MARTOS (ES)
(74) Representative: Valeo Visibility

(56) References cited:
- FR-A1- 3 056 702
- US-A1- 2008 299 819

## Description

### TECHNICAL FIELD

This invention is related to the field of automotive lighting devices, and more particularly, to the electric connections between elements comprised therein.

### STATE OF THE ART

Card edge connections are massively used in different electronic assemblies. Automotive vehicles also make use of these connections in their lighting devices, where multitude of different channels need independent control electric signals.

Such electronic devices are known from FR3056702A1.

The connection operation of a card edge connector is easy, since it relies on introducing a plane portion inside a female housing. No individual pins are used in these connections, so the risk of bending or breaking very thin elements is eliminated.

However, due to the ease of this connection operation, these two portions may be easily disconnected as well, and a reliable mechanism to detect an accidental disconnection is useful in these cases.

Connector position assurance pins are a good solution for this problem. One of the pins of the connector provides information about the connection state of the whole connector: if the connector position assurance pin is connected, the rest of the pins are connected for sure.

However, the main connector does not usually have such an amount of spare pins to be dedicated to this function.

A solution for this problem is therefore sought.

### SUMMARY OF THE INVENTION

The invention provides a solution for this problem by an electronic device as defined in claim 1.

With such an arrangement, the connection status of the first luminous module may be obtained from an impedance measurement between the electrically conductive part and the main ground connection, since the information about connection is transmitted to this element, which receives the equivalent resistance value of the resistors which are involved in the connection of the connector position assurance terminals. These resistor values provide a reliable information about the connection of the connector position assurance terminals without the need of a dedicated pin in the main connector.

In some embodiments, there is a single main power input but in other embodiments there are more than one main power input. This is a frequent arrangement when there is more than one function to be supplied.

The electrically conductive part is an element which has at least a portion which is accessible from the exterior of the luminous device (e.g., from the exterior of the zone defined by the housing and an outer lens, in a standard luminous device). The skilled person construes the meaning of the "exterior" of the luminous device without any effort.

The concept of "terminals" is used as a generic way of referring to the elements which produce the electric contact between a wired portion of a connector and the corresponding receptacle portion. In some cases, the connector is needles connector, so the first terminals are spring plates and the second terminals are needles (or vice versa). In other embodiments, the connector is a card edge connector, so the receptacle portion are the tracks of the circuit, while the wired portion comprise the complementary tracks which are to be connected with the tracks of the circuit. Hence, the concept of terminals may be extended to any type of male-female electrical connection, especially the ones used in automotive electric connections.

The first connector position assurance terminal is usually connected to the electrically conductive part by means of retention elements like screws, or by using blade springs, or a conductive paste, or by other means which do not need the use of physical wires. Conductive elements which may be simultaneously used for a different function may be used to perform this connection, thus saving material and, hence, reducing the final cost of the device.

In some particular embodiments, the electronic device further comprises a second module and a second module connector,
the second module comprises a second electronic circuit mounted with an electronic element and a ground connection;
the second module connector comprises a wired portion comprising first terminals and a receptacle portion affixed on the second electronic circuit comprising second terminals, the second terminals being configured to match with the first terminals to establish an electric connection;
at least one of the second terminals is in electric connection with the at least one light source;
one of the first terminals is a first connector position assurance terminal and one of the second terminals is a second connector position assurance terminal, configured to provide information about the connection status with the first connector position assurance terminal;
the second connector position assurance terminal is connected to the ground connection by the interposition of a second connection impedance and the first connection impedance comprises at least a second resistor; and
the first connector position assurance terminal of the second connector is connected to the first connector position assurance terminal of the first connector.

The invention is particularly advantageous when more than one module is involved, since all the first connector position assurance terminals (no matter how many of them there are) are connected together, and the equivalent impedance of the corresponding connector position assurance can therefore be measured in the electrically conductive element.

In some particular embodiments, the second resistor has a different value than the first resistor.

When more than one module is present, if each module is associated to a different resistor value, the resistor value measured at the conductive part not only provides information about how many connectors are connected, but also provides information about which connector is connected or not: for a given failed connection (i.e., when the first CPA terminal is not connected to the corresponding second CPA terminal), the particular measurement provides information to determine which is the specific connector that is not properly connected. This can be used for statistics on failed connections and so for better quality control and assembly procedures adjustment.

In some particular embodiments, the electronic element of the first electronic circuit and/or the electronic element of the second electronic circuit is a solid-state light source or an auxiliary electronic element which is configured to provide control or power supply to a solid-state light source.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the life span of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

The auxiliary electronic element may be a micro-controller or a driver, which is in charge of providing a controlled power to the light source.

In some particular embodiments, the first connector position assurance terminals are only connected with each other.

The first connection position assurance terminals have the relevant information of the connection status of the modules of the electronic device. Hence, when more than one module is present, it is enough that the first connection position assurance terminals are interconnected with each other to provide this information by means of the connection of the second connection position assurance terminal of the first electronic circuit with the electrically conductive element.

In some particular embodiments, at least one of the connection impedances also comprises a capacitor arranged in parallel with the corresponding resistor.

The role of such a capacitor is to let very high voltage peaks, caused by electrostatic discharges (ESDs) directly discharge to the ground without damaging other circuit elements. The parallel connection to the resistor allows the capacitor to desaturate when no tension is applied. On the other hand, the resistor (apart from the main function of providing information about connection) allows the reduction of the current in the event current would flow from the heatsink (e.g., if there is a contact with a power supply pin, which could happen during vehicle maintenance). The capacitor is saturated whenever a stationary current is supplied, even a weak current such as for a resistance measurement so the resistance measurement can be done without disturbance from the capacitor.

Hence, this parallel arrangement offers two independent advantages: on one side, it prevents damage from ESD/unwanted power supply on the heatsink and, on the other hand, it allows for CPA validation.

In some particular embodiments, the second connector position assurance terminal is configured to be the last in making electric contact with the corresponding first connector position assurance terminal.

One way to check electric connection between the wired portion and the receptacle portion is the fact that the electric connection between the first connector position assurance terminal and the second connector position assurance terminal is only performed once the connection between the rest of the terminals of the wired portion and the receptacle portion have taken place. One possible way of achieving this is by the second connector position assurance terminal ending at a distance from the connection line which is higher than the rest of the terminals. Since this second connector position assurance terminal ends "earlier", it is the last one to couple with their respective connector position assurance terminal. Hence, if this connector position assurance terminal is connected, it is sure that the rest of the terminals are connected as well. Other way of achieving this goal is by the first connector position assurance terminal being located at a different distance from the connection line that the rest of the first terminals. This is an alternative option based in the same principle: the second connector position assurance terminal is the last one to couple with their respective first connector position assurance terminal.

In some particular embodiments, the conductive part is a metallized element.

Metallization process are common in the manufacturing of automotive luminous devices, so there are some metallized elements which may be used in this context.

In some particular embodiments, the conductive part is a metallic element.

Instead of a metallized part, a metallic part may also be used.

In some particular embodiments, the conductive part is a heatsink.

In any case, either metallized or metallic, a heatsink is an element which is easily accessible to perform this measuring and which is a conductive part, so it is an especially adapted for this mission.

In some particular embodiments, the electronic device further comprises a housing and an outer lens, wherein the joint between the housing and the outer lens is watertight, and wherein the housing comprises holes which are sealed in a watertight manner.

This watertight connection is required by some car manufacturers, and the present invention is able to provide it without compromising the solution of the main technical problem, which is the detection of the correct connection of the connectors without using a dedicated pin in the main connector.

In some particular embodiments, the main connector is the only connector accessible from the exterior of the region defined by the housing and the outer lens. Further, in some particular embodiments, the connection position assurance pin is not connected to the main connector.

The fact that the main connector is the only connector which is accessible from the outside improves and simplifies the mechanical assembly within the automotive vehicle. Further, this arrangement help in the sense that the main connector does not usually have many spare pins. Providing CPA information without using a pin of the main connector is also advantageous.

In some particular embodiments, the first and/or the second module connector is a card edge connector.

This is one of the most representative embodiments, although not the only one. In this case, the receptacle portion would be the portion of the tracks of the circuit which are to be contacted by the corresponding matching tracks of the wired portion of the connector.

In some particular embodiments, each electronic circuit is comprised in a corresponding printed circuit board, and at least one of the printed circuit boards has a retention portion which forms a retention element, such as a pair of resilient arms, configured for resiliently receive the card edge connector and retaining it after reception.

These retention means are advantageous to prevent an accidental disconnection of the connectors.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### BRIEF LIST OF DRAWINGS AND REFERENCE NUMBERS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a general perspective view of an automotive vehicle comprising an automotive lighting device.
Figure 2 shows a scheme of the connection assembly of an automotive luminous device.
Figures 3 and 4 show two alternative arrangements in each of the connectors, to provide to each connector (and therefore to each printed circuit board) the ability of inform about the connection position assurance.
Figure 5 shows a first example of a sub-circuit connecting the position assurance tracks and the corresponding electric contacts in an automotive luminous device.
Figure 6 shows the connection of all the sub-circuits in an automotive luminous device.

In these figures, the following reference numbers have been used:
- 1: Main PCB
- 2: Driver
- 3: Main connector
- 4: First secondary PCB
- 5: First secondary connector
- 6: Second secondary PCB
- 7: Second secondary connector
- 8: Heatsink
- 9: LED
- 10: Headlamp
- 11: Edge portion of the main PCB
- 12: Third secondary PCB
- 13: Third secondary connector
- 14: Edge portion of the third secondary PCB
- 15: Inputs of the third secondary connector
- 17: Electric tracks
- 20: Second connector position assurance track
- 21: First branch
- 22: Second branch
- 23: Resistor
- 27: First connector position assurance terminal
- 28: Capacitor
- 30: Lighting module
- 31: Electrical inputs of the main connector
- 32: Electrical outputs of the main connector
- 41: Edge portion of the first secondary PCB
- 51: Electrical inputs of the first secondary connector
- 52: Electrical outputs of the first secondary connector
- 61: Edge portion of the second secondary PCB
- 71: Electrical inputs of the second secondary connector
- 72: Electrical outputs of the second secondary connector
- 100: Automotive vehicle

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Elements of the example embodiments are consistently denoted by the same reference numerals throughout the drawings and detailed description where appropriate.

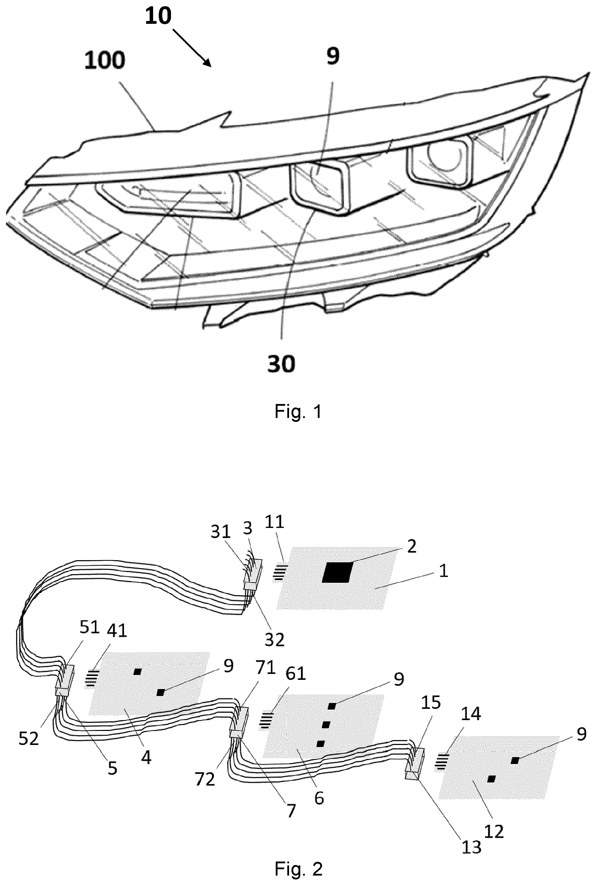

Figure 1 shows a general perspective view of an automotive lighting device 10 according to the invention.

This automotive lighting device 10 comprises a plurality of lighting modules 30. Each lighting module 30 comprises a plurality of light emitting diodes (LEDs) 9 arranged in a printed circuit board together with a driver configured to control the operation of these groups of LEDs.

The matrix configuration is a high-resolution module, having a resolution greater than 2000 pixels. However, no restriction is attached to the technology used for producing the projection modules.

A first example of this matrix configuration comprises a monolithic source. This monolithic source comprises a matrix of monolithic electroluminescent elements arranged in several columns by several rows. In a monolithic matrix, the electroluminescent elements can be grown from a common substrate and are electrically connected to be selectively activatable either individually or by a subset of electroluminescent elements. The substrate may be predominantly made of a semiconductor material. The substrate may comprise one or more other materials, for example non-semiconductors (metals and insulators). Thus, each electroluminescent element/group can form a light pixel and can therefore emit light when its/their material is supplied with electricity. The configuration of such a monolithic matrix allows the arrangement of selectively activatable pixels very close to each other, compared to conventional light-emitting diodes intended to be soldered to printed circuit boards. The monolithic matrix may comprise electroluminescent elements whose main dimension of height, measured perpendicularly to the common substrate, is substantially equal to one micrometre.

The monolithic matrix is coupled to the control centre so as to control the generation and/or the projection of a pixelated light beam by the matrix arrangement 6. The control centre is thus able to individually control the light emission of each pixel of the matrix arrangement.

Alternatively to what has been presented above, the matrix arrangement 6 may comprise a main light source coupled to a matrix of mirrors. Thus, the pixelated light source is formed by the assembly of at least one main light source formed of at least one light emitting diode emitting light and an array of optoelectronic elements, for example a matrix of micro-mirrors, also known by the acronym DMD, for "Digital Micro-mirror Device", which directs the light rays from the main light source by reflection to a projection optical element. Where appropriate, an auxiliary optical element can collect the rays of at least one light source to focus and direct them to the surface of the micro-mirror array.

Each micro-mirror can pivot between two fixed positions, a first position in which the light rays are reflected towards the projection optical element, and a second position in which the light rays are reflected in a different direction from the projection optical element. The two fixed positions are oriented in the same manner for all the micro-mirrors and form, with respect to a reference plane supporting the matrix of micro-mirrors, a characteristic angle of the matrix of micro-mirrors defined in its specifications. Such an angle is generally less than 20° and may be usually about 12°. Thus, each micro-mirror reflecting a part of the light beams which are incident on the matrix of micro-mirrors forms an elementary emitter of the pixelated light source. The actuation and control of the change of position of the mirrors for selectively activating this elementary emitter to emit or not an elementary light beam is controlled by the control centre.

In different embodiments, the matrix arrangement may comprise a scanning laser system wherein a laser light source emits a laser beam towards a scanning element which is configured to explore the surface of a wavelength converter with the laser beam. An image of this surface is captured by the projection optical element.

The exploration of the scanning element may be performed at a speed sufficiently high so that the human eye does not perceive any displacement in the projected image.

The synchronized control of the ignition of the laser source and the scanning movement of the beam makes it possible to generate a matrix of elementary emitters that can be activated selectively at the surface of the wavelength converter element. The scanning means may be a mobile micro-mirror for scanning the surface of the wavelength converter element by reflection of the laser beam. The micro-mirrors mentioned as scanning means are for example MEMS type, for "Micro-ElectroMechanical Systems". However, the invention is not limited to such a scanning means and can use other kinds of scanning means, such as a series of mirrors arranged on a rotating element, the rotation of the element causing a scanning of the transmission surface by the laser beam.

In another variant, the light source may be complex and include both at least one segment of light elements, such as light emitting diodes, and a surface portion of a monolithic light source.

Figure 2 shows a scheme of the connection assembly of an automotive luminous device according to the invention.

A main printed circuit board 1 comprises an electronic circuit. This electronic circuit starts in an edge portion 11 of the main printed circuit board 1 and communicate this edge portion 11 with a driver 2, which is intended to manage the lighting and signalling functions of the light sources located in the luminous device.

A main connector 3 is coupled to the edge portion 11 of the main substrate 1. This main connector 3 provides the main printed circuit board 1 with power supply and control signals coming from the body control module of the vehicle.

The main connector 3 comprises five electrical inputs 31 and five electrical outputs 32. The electrical inputs 31 are configured to transmit the power supply and the control signals to the main printed circuit board 1. To achieve this aim, they couple electrically to the electric tracks of the main substrate 1 when the main connector 3 is plugged into the edge portion 11 of the main printed circuit board 1.

The electrical connections described in these figures are performed by means of card edge connectors, so each printed circuit board has tracks as a particular example of the terminals of the receptacle portion of the connector, while the card edge connectors have tracks which correspond to the wired portion of the connectors. In different embodiments, the connection between the connectors and the circuits may be performed with different types of connections.

The electrical outputs 32 are also coupled to the electrical tracks of the opposite side of the main printed circuit board 1.

There are also three secondary printed circuit boards 4, 6, 12. In different embodiments, there may be more secondary printed circuit boards, since the invention is not limited to a specific number of them.

Each secondary printed circuit boards 4, 6, 12 comprises a LED 9 and electric tracks which communicate the edge portions 41, 61, 14 of the corresponding secondary printed circuit board with the corresponding LED 9.

The LEDs 9 of each secondary printed circuit board 4, 6, 12 are intended to be controlled by the driver 2 of the main printed circuit board 1.

This control is achieved by means of a daisy-chain connection, as shown in Figure 1.

The main connector 3 is coupled to the edge portion 11 of the main printed circuit board 1. Each electrical input 31 is configured to receive power supply and control signals from the body control module and is electrically coupled to an electric track of the main printed circuit board 1. After feeding the circuit of the main printed circuit board 1, the electric tracks of the opposite side are coupled to the electrical outputs 32 of the main connector 3.

The first secondary connector 5 is coupled to the edge portion of the first secondary printed circuit board 4. The first secondary connector comprises five inputs 51, each input 51 being connected by wire with one output 32 of the main connector 3. After feeding the circuit of the first secondary printed circuit board 4, the electric tracks of the opposite side are coupled to the electrical outputs 52 of the first secondary connector 5.

The second secondary connector 7 is coupled to the edge portion of the second secondary printed circuit board 6. The second secondary connector 7 comprises five inputs 71, each input 71 being connected by wire with one output 52 of the first secondary connector 5. After feeding the circuit of the second secondary printed circuit board 6, the electric tracks of the opposite side are coupled to the electrical outputs 72 of the second secondary connector 7.

The third secondary connector 13 is coupled to the edge portion of the third secondary printed circuit board 12. The third secondary connector 13 comprises five inputs 15, each input 15 being connected by wire with one output 72 of the second secondary connector 7.

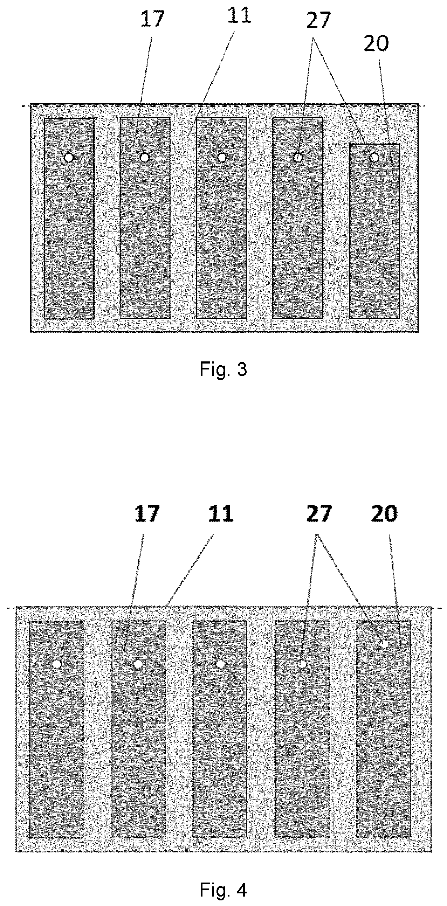

Figures 3 and 4 show two alternative arrangements in each of the connectors, to provide to each connector the ability of inform about the connection position assurance.

Figure 3 shows a first alternative to achieve this aim, showing the arrangement of the second connector position assurance track 20 and its respective first connector position assurance terminal 27 in a plan view.

Each conductive track 17 reaches its respective connector terminal and the second connector position assurance track 20 is shorter than the rest of the second tracks 17, thus ending at a distance from the edge of the connector 11 which is higher than the rest of the second tracks 17.

With this arrangement, the second connector position assurance track 20 is the last to be connected to its respective first connector position assurance terminal 27, thus ensuring that, if this connection is produced, the rest of the electric connections are achieved.

Figure 4 shows a second alternative to achieve this condition. In this case, the same aim of the embodiment of Figure 3 is achieved by the relative position of the first connector position assurance terminal 27 which intends to connect the second connector position assurance track 20. This first connector position assurance terminal 27 is located closer to the edge of the connector 11 than the rest of the first terminals. With this position, it is ensured that, when the second connector position assurance track 20 reaches its first connector position assurance terminal 27, the rest of the conductive tracks have reached theirs.

In both figures 3 and 4, it is seen how the second connector position assurance track is located on the external fifth of the line of conductive tracks. In this case, since there are only five tracks, this means that the connection position assurance track is located in the end of the conductive tracks (the more external one).

Therefore, with any of the embodiments shown in Figures 3 or 4 (or with any equivalent embodiment which provides a terminal with the possibility of transmitting information about connection position assurance), each printed circuit board has means to produce information about the connection position assurance.

This connection between the second connector position assurance track 20 and its corresponding first connector position assurance terminal feeds one sub-circuit which is independent from the one of the light source.

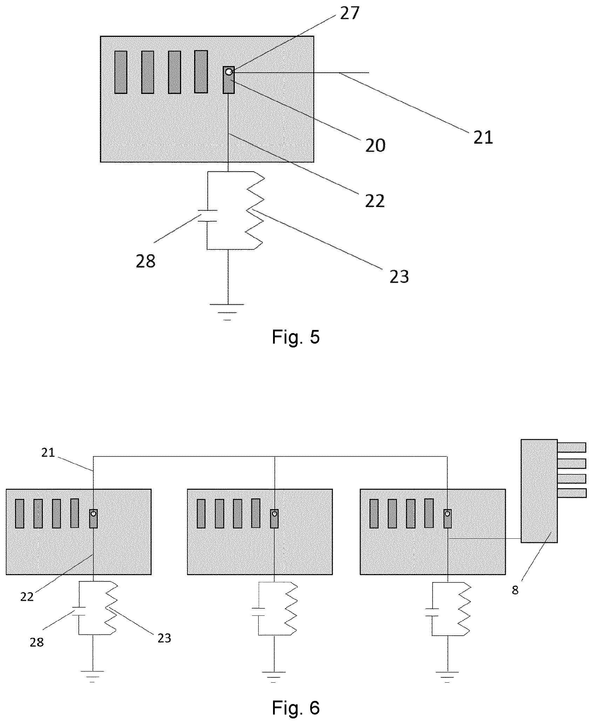

Figure 5 shows a first example of this sub-circuit. The components of this sub-circuit do not actively participate in the lighting function performed by the LEDs. The main function of this sub-circuit is to cooperate electrically with the contact between the second connector position assurance track 20 and its first connector position assurance terminal 27. The presence of current in this line of the circuit indicates that the connection is successfully achieved so all of the electric tracks are successfully coupled with the corresponding terminals of the wired portion of the connector.

This sub-circuit has a first branch 21, which contains the first connector position assurance terminal 27, and a second branch 22, which comprises an impedance which comprises a parallel connection of a resistor 23 and a capacitor 28, this impedance being grounded. When the circuit is closed (i.e., when the second connector position assurance track is connected to the first connector position assurance terminal 27), the first branch sees this impedance value.

The role of the capacitor 28 is to let very high voltage peaks, caused by electrostatic discharges (ESDs) directly discharge to the ground without damaging other circuit elements. The parallel connection to the resistor allows the capacitor to desaturate when no tension is applied. On the other hand, the resistor (apart from the main function of providing information about connection) allows the reduction of the current in the event current would flow from the heatsink (e.g., if there is a contact with a power supply pin, which could happen during vehicle maintenance). The capacitor is saturated whenever a stationary current is supplied, even a weak current such as for a resistance measurement so the resistance measurement can be done without disturbance from the capacitor.

Figure 6 shows the connection of all the sub-circuits according to an embodiment of the invention. In this case, the first connector position assurance terminals are connected in parallel and the second connector position assurance track is put in electric contact with the heatsink 8. This last step may be performed by means of electrically conductive elements which may be simultaneously used for a different function may be used to perform this connection, such as screws, or by blade springs, or a conductive paste, or by other means which do not need the use of physical wires. An ulterior resistance measurement of the value in the heatsink 8 will provide the parallel-connection value of the resistors which are connected, due to the fact that the capacitors do not disturb the resistance measurement.

Since each sub-circuit has its own resistor value, the resistance value measured between the heatsink and the ground connection provides information about the connection state of every printed circuit board: if every connector is properly connected, the resistance value will see all the resistors in parallel. However, if one of them is not connected, the resistance value will see a different value, depending on which is the resistor that is not connected to the circuit. Thus, the control of all the printed circuit boards is performed with a single resistance measurement. If the first resistor value is 1 Ω, the second resistor value is 2 Ω and the third resistor value is 3 Ω, when the first and third are connected, the measured value will be 0.75 Ω. When the first and second are connected, the equivalent is 0.67 Ω, when the second and third are connected, the measured value will be 1.2 Ω and when all of them are connected, 0.55 Ω will be measured. Hence, depending on the value, the operator may know whether everything is connected or not and, in case there is a module which is not connected, which module or modules are not connected.

As may be seen in this figure, the first connector position assurance terminals are only connected between themselves. In different embodiments, this connection could be slightly different, by means of the interposition of known elements which may cause known affections in the resistance measurement. These known elements may be predetermined impedances or circuit boards, but in any case, the CPA circuit, comprising the first CPA terminals and these known elements, is not mixed with the circuits in charge of providing the lighting and/or signalling functions to the vehicle.

## Claims

1. Electronic device (10) for an automotive vehicle, the electronic device (10) comprising a main connector (3), a first module (30), a first module connector (5) and an electrically conductive part (8) comprising at least a portion accessible from the exterior of the electronic device, wherein
the main connector (3) comprises a at least a main power input terminal and a main ground terminal;
the first module (30) comprises a first electronic circuit (4) mounted with an electronic element (9) and a ground connection which is in electrical connection with a main ground connection;
the first module connector (5) comprises a wired portion comprising first terminals and a receptacle portion affixed on the first electronic circuit (4) comprising second terminals, the second terminals being configured to match with the first terminals to establish an electric connection;
at least one of the second terminals is in electric connection with the electronic element (9);
one of the first terminals is a first connector position assurance terminal (27) and one of the second terminals is a second connector position assurance terminal (20), configured to provide information about the connection status with the first connector position assurance terminal (27), the information about the connection status being the connection status of the first electronic circuit (4) with the first module connector (5), wherein the connection status is obtained from an impedance measurement between the electrically conductive part and the main ground connection;
the second connector position assurance terminal (20) is connected to the ground connection of the first electronic circuit by the interposition of a first connection impedance and the first connection impedance comprises at least a first resistor (23); and
the second connector position assurance terminal (20) is connected to the electrically conductive part (8).

2. Electronic device (10) according to claim 1, further comprising a second module and a second module connector (7),
the second module comprises a second electronic circuit (6) mounted with an electronic element (9) and a ground connection;
the second module connector (7) comprises a wired portion comprising first terminals and a receptacle portion affixed on the second electronic circuit (6) comprising second terminals, the second terminals being configured to match with the first terminals to establish an electric connection;
at least one of the second terminals is in electric connection with the electronic element (9);
one of the first terminals is a first connector position assurance terminal (27) and one of the second terminals is a second connector position assurance terminal (20), configured to provide information about the connection status with the first connector position assurance terminal (27);
the second connector position assurance terminal (20) is connected to the ground connection by the interposition of a second connection impedance and the first connection impedance comprises at least a second resistor; and
the first connector position assurance terminal (27) of the second connector (7) is connected to the first connector position assurance terminal (27) of the first connector (5).

3. Electronic device (10) according to claim 2, wherein the second resistor has a different value than the first resistor (23).

4. Electronic device (10) according to any of the preceding claims, wherein the electronic element of the first electronic circuit and/or the electronic element of the second electronic circuit is a solid-state light source (9) or an auxiliary electronic element which is configured to provide control or power supply to a solid-state light source (9).

5. Electronic device (10) according to any of the preceding claims, wherein the first connector position assurance terminals (27) are only connected with each other.

6. Electronic device (10) according to any of the preceding claims, wherein at least one of the connection impedances also comprises a capacitor (28) arranged in parallel with the corresponding resistor (23).

7. Electronic device (10) according to any of the preceding claims, wherein the second connector position assurance terminal (20) is configured to be the last in making electric contact with the corresponding first connector position assurance terminal (27).

8. Electronic device (10) according to any of the preceding claims, wherein the electrically conductive part is a metallized element or a metallic element.

9. Electronic device (10) according to any of the preceding claims, wherein the electrically conductive part is a heatsink (8).

10. Electronic device (10) according to any of the preceding claims, further comprising a housing and an outer lens, wherein the joint between the housing and the outer lens is watertight, and wherein the housing comprises holes which are sealed in a watertight manner.

11. Electronic device (10) according to claim 10, wherein the main connector (3) is the only connector accessible from the exterior of the region defined by the housing and the outer lens.

12. Electronic device (10) according to any of the preceding claims, wherein the first and/or the second module connector is a card edge connector.

13. Electronic device (10) according to claim 11, wherein each electronic circuit is comprised in a corresponding printed circuit board, and at least one of the printed circuit boards has a retention portion which forms a retention element, such as a pair of resilient arms, configured for resiliently receive the card edge connector and retaining it after reception.

## Patentansprüche

1. Elektronisches Gerät (10) für ein Kraftfahrzeug, wobei das elektronische Gerät (10) einen Hauptverbinder (3), ein erstes Modul (30), einen ersten Modulverbinder (5) und ein elektrisch leitendes Teil (8) umfasst, das mindestens einen von außen zugänglichen Abschnitt des elektronischen Geräts aufweist, wobei
der Hauptverbinder (3) mindestens einen Hauptstromeingangsklemme und eine Hauptmasseklemme umfasst;
das erste Modul (30) einen ersten elektronischen Schaltkreis (4) umfasst, der mit einem elektronischen Element (9) und einer Masseverbindung montiert ist, die in elektrischer Verbindung mit einer Hauptmasseverbindung steht;
der erste Modulverbinder (5) einen verdrahteten Abschnitt mit ersten Klemmen und einen auf dem ersten elektronischen Schaltkreis (4) befestigten Aufnahmeabschnitt mit zweiten Klemmen umfasst, wobei die zweiten Klemmen so konfiguriert sind, dass sie mit den ersten Klemmen übereinstimmen, um eine elektrische Verbindung herzustellen;
mindestens eine der zweiten Klemmen in elektrischer Verbindung mit dem elektronischen Element (9) steht;
eine der ersten Klemmen eine erste Verbinderpositionssicherungsklemme (27) und eine der zweiten Klemmen eine zweite Verbinderpositionssicherungsklemme (20) ist, die so konfiguriert ist, dass sie Informationen über den Verbindungsstatus mit der ersten Verbinderpositionssicherungsklemme (27) liefert, wobei die Informationen über den Verbindungsstatus den Verbindungsstatus des ersten elektronischen Schaltkreises (4) mit dem ersten Modulverbinder (5) darstellen, wobei der Verbindungsstatus aus einer Impedanzmessung zwischen dem elektrisch leitenden Teil und der Hauptmasseverbindung gewonnen wird;
die zweite Verbinderpositionssicherungsklemme (20) durch Zwischenschaltung einer ersten Verbindungsimpedanz mit der Masseverbindung des ersten elektronischen Schaltkreises verbunden ist und die erste Verbindungsimpedanz mindestens einen ersten Widerstand (23) umfasst; und
die zweite Verbinderpositionssicherungsklemme (20) mit dem elektrisch leitenden Teil (8) verbunden ist.

2. Elektronisches Gerät (10) nach Anspruch 1, das ferner ein zweites Modul und einen zweiten Modulverbinder (7) umfasst, wobei das zweite Modul einen zweiten elektronischen Schaltkreis (6) umfasst, der mit einem elektronischen Element (9) und einer Masseverbindung montiert ist;
der zweite Modulverbinder (7) einen verdrahteten Abschnitt mit ersten Klemmen und einen auf dem zweiten elektronischen Schaltkreis (6) befestigten Aufnahmeabschnitt mit zweiten Klemmen umfasst, wobei die zweiten Klemmen so konfiguriert sind, dass sie mit den ersten Klemmen übereinstimmen, um eine elektrische Verbindung herzustellen;
mindestens eine der zweiten Klemmen in elektrischer Verbindung mit dem elektronischen Element (9) steht;
eine der ersten Klemmen eine erste Verbinderpositionssicherungsklemme (27) und eine der zweiten Klemmen eine zweite Verbinderpositionssicherungsklemme (20) ist, die so konfiguriert ist, dass sie Informationen über den Verbindungsstatus mit der ersten Verbinderpositionssicherungsklemme (27) liefert;
die zweite Verbinderpositionssicherungsklemme (20) durch Zwischenschaltung einer zweiten Verbindungsimpedanz mit der Masseverbindung verbunden ist und die erste Verbindungsimpedanz mindestens einen zweiten Widerstand umfasst;
und die erste Verbinderpositionssicherungsklemme (27) des zweiten Verbinders (7) mit der ersten Verbinderpositionssicherungsklemme (27) des ersten Verbinders (5) verbunden ist.

3. Elektronisches Gerät (10) nach Anspruch 2, wobei der zweite Widerstand einen anderen Wert als der erste Widerstand (23) hat.

4. Elektronisches Gerät (10) nach einem der vorhergehenden Ansprüche, wobei das elektronische Element des ersten elektronischen Schaltkreises und/oder das elektronische Element des zweiten elektronischen Schaltkreises eine Festkörper-Lichtquelle (9) oder ein auxiliäres elektronisches Element ist, das so konfiguriert ist, dass es die Steuerung oder Stromversorgung einer Festkörper-Lichtquelle (9) bereitstellt.

5. Elektronisches Gerät (10) nach einem der vorhergehenden Ansprüche, wobei die ersten Verbinderpositionssicherungsklemmen (27) nur miteinander verbunden sind.

6. Elektronisches Gerät (10) nach einem der vorhergehenden Ansprüche, wobei mindestens eine der Verbindungsimpedanzen auch einen Kondensator (28) umfasst, der parallel zum entsprechenden Widerstand (23) angeordnet ist.

7. Elektronisches Gerät (10) nach einem der vorhergehenden Ansprüche, wobei die zweite Verbinderpositionssicherungsklemme (20) so konfiguriert ist, dass sie als letzte den elektrischen Kontakt mit der entsprechenden ersten Verbinderpositionssicherungsklemme (27) herstellt.

8. Elektronisches Gerät (10) nach einem der vorhergehenden Ansprüche, wobei das elektrisch leitende Teil ein metallisiertes Element oder ein metallisches Element ist.

9. Elektronisches Gerät (10) nach einem der vorhergehenden Ansprüche, wobei das elektrisch leitende Teil ein Kühlkörper (8) ist.

10. Elektronisches Gerät (10) nach einem der vorhergehenden Ansprüche, das ferner ein Gehäuse und eine Außenlinse umfasst, wobei die Verbindung zwischen dem Gehäuse und der Außenlinse wasserdicht ist und wobei das Gehäuse Öffnungen aufweist, die wasserdicht versiegelt sind.

11. Elektronisches Gerät (10) nach Anspruch 10, wobei der Hauptverbinder (3) der einzige Verbinder ist, der von außen aus dem durch das Gehäuse und die Außenlinse definierten Bereich zugänglich ist.

12. Elektronisches Gerät (10) nach einem der vorhergehenden Ansprüche, wobei der erste und/oder der zweite Modulverbinder ein Kartenkanten-Verbinder ist.

13. Elektronisches Gerät (10) nach Anspruch 11, wobei jeder elektronische Schaltkreis in einer entsprechenden Leiterplatte enthalten ist und mindestens eine der Leiterplatten einen Halteabschnitt aufweist, der ein Halteelement bildet, wie beispielsweise ein Paar federnder Arme, das so konfiguriert ist, dass es den Kartenkanten-Verbinder federnd aufnimmt und nach der Aufnahme festhält.

## Revendications

1. Dispositif électronique (10) pour un véhicule automobile, le dispositif électronique (10) comprenant un connecteur principal (3), un premier module (30), un premier connecteur de module (5) et une partie électriquement conductrice (8) comprenant au moins une portion accessible depuis l'extérieur du dispositif électronique, dans lequel
le connecteur principal (3) comprend au moins une borne d'alimentation électrique principale et une borne de masse principale ;
le premier module (30) comprend un premier circuit électronique (4) monté avec un élément électronique (9) et une connexion de masse qui est en connexion électrique avec une connexion de masse principale ;
le premier connecteur de module (5) comprend une portion câblée comprenant des premières bornes et une portion réceptacle fixée sur le premier circuit électronique (4) comprenant des secondes bornes, les secondes bornes étant configurées pour correspondre aux premières bornes afin d'établir une connexion électrique ;
au moins une des secondes bornes est en connexion électrique avec l'élément électronique (9) ;
l'une des premières bornes est une première borne d'assurance de position de connecteur (27) et l'une des secondes bornes est une seconde borne d'assurance de position de connecteur (20), configurée pour fournir des informations sur l'état de connexion avec la première borne d'assurance de position de connecteur (27), les informations sur l'état de connexion étant l'état de connexion du premier circuit électronique (4) avec le premier connecteur de module (5), dans lequel l'état de connexion est obtenu à partir d'une mesure d'impédance entre la partie électriquement conductrice et la connexion de masse principale;
la seconde borne d'assurance de position de connecteur (20) est connectée à la connexion de masse du premier circuit électronique par l'interposition d'une première impédance de connexion et la première impédance de connexion comprend au moins une première résistance (23) ; et
la seconde borne d'assurance de position de connecteur (20) est connectée à la partie électriquement conductrice (8).

2. Dispositif électronique (10) selon la revendication 1, comprenant en outre un second module et un second connecteur de module (7),
le second module comprend un second circuit électronique (6) monté avec un élément électronique (9) et une connexion de masse ;
le second connecteur de module (7) comprend une portion câblée comprenant des premières bornes et une portion réceptacle fixée sur le second circuit électronique (6) comprenant des secondes bornes, les secondes bornes étant configurées pour correspondre aux premières bornes afin d'établir une connexion électrique ;
au moins une des secondes bornes est en connexion électrique avec l'élément électronique (9) ;
l'une des premières bornes est une première borne d'assurance de position de connecteur (27) et l'une des secondes bornes est une seconde borne d'assurance de position de connecteur (20), configurée pour fournir des informations sur l'état de connexion avec la première borne d'assurance de position de connecteur (27) ;
la seconde borne d'assurance de position de connecteur (20) est connectée à la connexion de masse par l'interposition d'une seconde impédance de connexion et la première impédance de connexion comprend au moins une seconde résistance ; et
la première borne d'assurance de position de connecteur (27) du second connecteur (7) est connectée à la première borne d'assurance de position de connecteur (27) du premier connecteur (5).

3. Dispositif électronique (10) selon la revendication 2, dans lequel la seconde résistance a une valeur différente de celle de la première résistance (23).

4. Dispositif électronique (10) selon l'une quelconque des revendications précédentes, dans lequel l'élément électronique du premier circuit électronique et/ou l'élément électronique du second circuit électronique est une source lumineuse à semi-conducteurs (9) ou un élément électronique auxiliaire qui est configuré pour fournir une commande ou une alimentation électrique à une source lumineuse à semi-conducteurs (9).

5. Dispositif électronique (10) selon l'une quelconque des revendications précédentes, dans lequel les premières bornes d'assurance de position de connecteur (27) sont uniquement connectées entre elles.

6. Dispositif électronique (10) selon l'une quelconque des revendications précédentes, dans lequel au moins une des impédances de connexion comprend également un condensateur (28) disposé en parallèle avec la résistance correspondante (23).

7. Dispositif électronique (10) selon l'une quelconque des revendications précédentes, dans lequel la seconde borne d'assurance de position de connecteur (20) est configurée pour être la dernière à établir un contact électrique avec la première borne d'assurance de position de connecteur correspondante (27).

8. Dispositif électronique (10) selon l'une quelconque des revendications précédentes, dans lequel la partie électriquement conductrice est un élément métallisé ou un élément métallique.

9. Dispositif électronique (10) selon l'une quelconque des revendications précédentes, dans lequel la partie électriquement conductrice est un dissipateur thermique (8).

10. Dispositif électronique (10) selon l'une quelconque des revendications précédentes, comprenant en outre un boîtier et une lentille extérieure, dans lequel le joint entre le boîtier et la lentille extérieure est étanche à l'eau, et dans lequel le boîtier comprend des orifices qui sont obturés de manière étanche à l'eau.

11. Dispositif électronique (10) selon la revendication 10, dans lequel le connecteur principal (3) est le seul connecteur accessible depuis l'extérieur de la région définie par le boîtier et la lentille extérieure.

12. Dispositif électronique (10) selon l'une quelconque des revendications précédentes, dans lequel le premier et/ou le second connecteur de module est un connecteur à insertion sur carte.

13. Dispositif électronique (10) selon la revendication 11, dans lequel chaque circuit électronique est compris dans une carte de circuit imprimé correspondante, et au moins une des cartes de circuit imprimé présente une portion de rétention qui forme un élément de rétention, tel qu'une paire de bras élastiques, configuré pour recevoir de manière élastique le connecteur à insertion sur carte et le retenir après réception.
